(19) Europäisches Patentamt
European Patent Office
Office européen des brevets

(11) Publication number: 0 366 846 A1

(12) EUROPEAN PATENT APPLICATION

(21) Application number: 88310415.0

(22) Date of filing: 04.11.88

(51) Int. Cl.[5] C08L 67/00 , C08K 3/00 , C08K 7/14 , C08G 63/60 , H05K 5/00 , H01R 13/527 , H05K 1/03

(43) Date of publication of application: 09.05.90 Bulletin 90/19

(84) Designated Contracting States: AT BE CH DE ES FR GB GR IT LI LU NL SE

(71) Applicant: MITSUI PETROCHEMICAL INDUSTRIES, LTD.
2-5, Kasumigaseki 3-chome Chiyoda-ku
Tokyo 100(JP)

(72) Inventor: Ikejiri, Fumitoshi
63-23 Yamatecho 2-chome
Iwakuni-shi Yamaguchi(JP)
Inventor: Fukui, Kunisuke
6832-1 Oonocho
Saikigun Hiroshima(JP)

(74) Representative: Myerscough, Philip Boyd et al
J.A.Kemp & Co. 14, South Square Gray's Inn
London, WC1R 5EU(GB)

# (54) Wholly aromatic polyester composition and use thereof.

(57) The present invention provides compositions which contain a melt-moldable wholly aromatic polyester consisting essentially of:

(A) structural units A derived from at least one aromatic hydroxycarboxylic acid, represented by the formula (i)

$- CO - Ar^1 - O -$ (i)

wherein $Ar^1$ is a divalent aromatic hydrocarbon group and at least 60 mol% of $Ar^1$ is p-phenylene group;

(B) structural units B derived from at least one aromatic diol, represented by the formula (ii)

$- O - Ar^2 - O -$ (ii)

wherein $Ar^2$ is a divalent aromatic group selected from the class consisting of p-phenylene and 4,4′-biphenylene groups;

(C) structural units C derived from 4,4′-dihydroxydiphenyl ether, represented by the formula (iii)

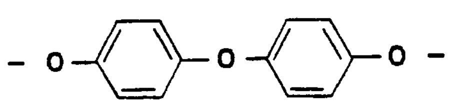 ... (iii)

and

(D) structural units D derived from at least one aromatic dicarboxylic acid, represented by the formula (iv)

$- CO - Ar^3 - CO -$ (iv)

wherein $Ar^3$ is a divalent aromatic hydrocarbon group and at least 60 mol% of $Ar^3$ is p-phenylene group; in such proportions that the amount of the units A is 30 to 80 mol%, that of the units B is 1 to 20 mol%, that of the units C is 1 to 32 mol% and that of the units D is 10 to 35 mol%, based on the sum of moles of the units A, B, C and D, with the proviso that the sum of moles of the units B and C being substantially equal to moles of the units D. Uses of said compositions are also disclosed.

EP 0 366 846 A1

# WHOLLY AROMATIC POLYESTER COMPOSITION AND USE THEREOF

## TECHNICAL FIELD OF THE INVENTION

The present invention relates to wholly aromatic polyester compositions containing a wholly aromatic polyester and use thereof, and more particularly to wholly aromatic polyester compositions having improved anisotropy in mechanical strength and excellent mechanical characteristics, resistance to heat and resistance to hydrolysis at high temperatures and use thereof.

## TECHNICAL BACKGROUND OF THE INVENTION AND PROBLEMS THEREOF

It is known that p-hydroxybenzoate polyesters are aromatic polyesters having excellent heat resistance. However, the p-hydroxybenzoate polyesters have disadvantages in that there is much difficulty in obtaining those having a high molecular weight and they are liable to be heat-decomposed during melting so that they cannot be subjected to conventional melt-molding methods such as injection molding and extrusion. Accordingly, they are scarcely utilized industrially, though they are excellent in heat resistance.

Aromatic polyesters obtained by co polycondensation of various aromatic dicarboxylic acid compounds with various aromatic diol components have been proposed for the purpose of eliminating these drawbacks associated with the p-hydroxybenzoate polyesters.

For example there is disclosed in U.S. Patent No. 3,637,595 (corresponding to Japanese Patent Publication No. 47870/1972) a process for producing a heat-resistant polyester comprising condensing p-hydroxybenzoic acid and an aromatic dicarbonyl compound with an aromatic dioxy compound.

U.S. Patent No. 4,603,190 (corresponding to Japanese Patent Laid-Open Publication No. 38425/1985) discloses wholly aromatic polyesters obtained by condensing p-hydroxybenzoic acid, isophthalic acid, terephthalic acid, hydroquinone, 3,4′-dihydroxybiphenyl, 3,4′-dihydroxydiphenyl ether, etc. in specified proportions.

Although the p-hydroxybenzoate polyesters disclosed in the above-mentioned patent specifications have an improved melt moldability because of their lower melting points than those of p-hydroxybenzoate homopolyesters they are still disadvantageous in their low heat resistance unsatisfactory, mechanical characteristics including stiffness modulus, tensile strength and impact strength and poor water and chemical resistances.

The present inventors have proposed in Japanese Patent Application No.260767/1986 wholly aromatic polyesters obtained by copolymerizing p-hydroxybenzoic acid, 4,4′-diacetoxydiphenyl, 4,4′-diacetoxydiphenyl ether and terephthalic acid which polyesters are free from the above-described problems and have excellent heat resistance as well as mechanical characteristics such as excellent stiffness modulus, tensile strength, etc.

The inventors have found that the above-described aromatic polyesters have still the following disadvantages. Molecular chains of the polyesters are strongly orientated in the direction of flow during molding. Thus, molded articles obtained from said wholly aromatic polyesters have excellent strength in the direction of flow as in glass fiber-reinforced plastics. However, the strength of the molded articles is low in the direction perpendicular to the direction of flow and hence the molded articles causes warpage, or are inferior in weld strength.

The present inventors have studieds to eliminate the above-described drawbacks. As a result, the inventors have found that when a specified amount of a filler is added to the wholly aromatic polyesters, anisotropy in the mechanical strength of the molded articles obtained from the wholly aromatic polyesters can be greatly reduced. The present invention is based on the above finding.

Further, the present inventors have found that said wholly aromatic polyesters and wholly aromatic polyester compositions containing a filler added thereto have excellent characteristics as sealing materials for electronic components such as capacitors, resistors, integrated circuits, etc. Furthermore, the present inventors have found that the wholly aromatic polyesters and the wholly aromatic polyester compositions have excellent characteristics as connectors for electrical and electronic circuits and as base boards for printed circuits.

Further, the present inventors have found that they have excellent moldability and can be injection-molded or extruded into various articles. Particularly, it has been found that wholly aromatic polyester

compositions which can be molded into fibrous materials by a melt spining method as for polyethylene terephthalate, can be obtained by blending said wholly aromatic polyester with a synthetic thermoplastic resin.

## OBJECT OF THE INVENTION

Accordingly, it is an object of the present invention to provide wholly aromatic polyesters which are free from the problems associated with conventional wholly aromatic polyesters, and which have an improved anisotropy in mechanical strength and have excellent mechanical characteristics such as stiffness modulus, tensile strength, impact strength, etc., and have high resistance to heat, high resistance to hydrolysis at high temperatures and further high melt-moldability and which can be widely used in various applications.

It is another object of the present invention to provide uses of such wholly aromatic polyesters and wholly aromatic polyester compositions.

It is still another object of the present invention to provide wholly aromatic polyester compositions which have excellent moldability, can be injection molded or extruded into various articles and in particular, can be molded into fibrous articles by melt spinning.

## SUMMARY OF THE INVENTION

A first wholly aromatic polyester compositions of the present invention comprise:

[I] a melt-moldable wholly aromatic polyester consisting essentially of:

(A) structural units A derived from at least one aromatic hydroxy carboxylic acid, represented by the formula (i)

- CO - $Ar^1$ - O - (i)

wherein $Ar^1$ is a divalent aromatic hydrocarbon group and at least 60 mol% of $Ar^1$ is p-phenylene group;

(B) structural units B derived from at least one aromatic diol, represented by the formula (ii)

- O - $Ar^2$ - O - (ii)

wherein $Ar^2$ is a divalent aromatic group selected from the class consisting of p-phenylene and 4,4′-biphenylene groups;

(C) structural units C derived from 4,4′-dihydroxydiphenyl ether, represented by the formula (iii)

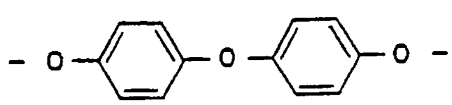

... (iii)

and

(D) structural units D derived form at least one aromatic dicarboxylic acid, represented by the formula (iv)

- CO - $Ar^3$ - CO - (iv)

wherein $Ar^3$ is a divalent aromatic hydrocarbon group and at least 60% of $Ar^3$ is p-phenylene group; in such a proportions that the amount of the units A is 30 to 80 mol%, that of the units B is 1 to 20 mol%, that of the units C is 1 to 32 mol% and that of the units D is 10 to 35 mol%, based on the sum of moles of the units A, B, C and D, with the proviso that the sum of moles of the units B and C is substantially equal to moles of the units (D); and

[II] a filler in such a proportion that the ratio of said wholly aromatic polyester to said filler [II] is from 10/90 to 90/10 by weight.

A second wholly aromatic polyester compositions of the present invention comprise:

[I] a melt-moldable wholly aromatic polyester consisting essentially of:

(A) structural units A derived from at least one aromatic hydroxycarboxylic acid, represented by the formula (i)

- CO - $Ar^1$ - O - (i)

wherein $Ar^1$ is a divalent aromatic hydrocarbon group and at least 60 mol% of $Ar^1$ is p-phenylene;

(C) 'structural units C' derived from at least one aromatic diol, represented by the formula (ii)

- O - $Ar^4$ - O - (ii)
wherein $Ar^4$ is a divalent aromatic group, and at least 60 mol% of $Ar^4$ is selected from the class consisting of a group having the following formula (a)

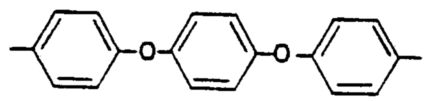

... (a)

and a group having the following formula (b)

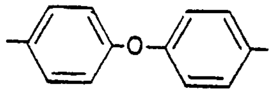

... (b)

and

(D) structural units D derived from at least one aromatic dicarboxylic acid, represented by the formula (iii)
- CO - $Ar^3$ - CO - (iii)
wherein $Ar^3$ is a divalent aromatic hydrocarbon group and at least 60 mol% of $Ar^3$ is p-phenylene group; in such proportions that the amount of the units A is 30 to 80 mol%, that of the units C′ is 10 to 35 mol% and that of the units D is 10 to 35 mol%, based on the sum of moles of the units A, C′ and D, with the proviso that moles of the units C′ is substantially equal to moles of the units D; and

[II] a filler in such a proportion that the ratio of said wholly aromatic polyester [I] to said filler [II] is from 10/90 to 90/10 by weight.

The wholly aromatic polyester compositions of the present invention have reduced anisotropy in mechanical strength in direction, excellent mechanical characteristics such as stiffness modulus, tensile strength, impact resistance, etc., excellent heat resistance, excellent hydrolysis resistance and further enhanced melt moldability. They can be widely used in various applications.

The wholly aromatic polyesters and the wholly aromatic polyester compositions of the present invention can be used as sealing materials for electronic components, as connectors for electrical and electronic circuits and as base boards for printed circuits.

Further, the present invention provides wholly aromatic polyester compositions obtained by blending the wholly aromatic polyester with a synthetic thermoplastic resin.

## DETAILED DESCRIPTION OF THE INVENTION

Now, the wholly aromatic polyester composition of the present invention will be illustrated in more detail hereinbelow.

### Structural units of wholly aromatic polyester

The wholly aromatic polyester in the wholly aromatic polyester composition according to the present invention has a polymer chain composed the following species of redisues: (A) residue of aromatic hydroxycarboxylic acid: (B) residue of aromatic diol: (C) residue of 4,4′-dihydroxydiphenyl ether and (D) residue of aromatic dicarboxylic acid. Each of these structural units will be illustrated below.

### (A) Residue of aromatic hydroxycarboxylic acid

The units A are derived from at least one aromatic hydroxycarboxylic and are represented by the formula (i) wherein $Ar^1$ is p-phenylene group which is the residue of p-hydroxybenzoic acid, or at least 60 mol% of $Ar^1$ is p-phenylene group and the remainder of $Ar^1$ is a divalent aromatic hydrocarbon group such as m-phenylene or 2,6-naphthylene group other than p-phenylene group.

It is preferred that at least 80 mol%, particularly 90 mol% the units A are composed of the residue of p-hydroxybenzoic acid.

To introduce the units A into the main chain of the polymer in the production of the wholly aromatic polyester of the present invention, there are used ester forming derivatives of aromatic hydroxycarboxylic acids having the following formula:

HOOC - $Ar^{11}$ - OH

wherein $Ar^{11}$ is a divalent aromatic hydrocarbon group such as p-phenylene group.

Examples of the hydroxycarboxylic acid having the formula HOOC-$Ar^{11}$-OH include p-hydroxybenzoic acid, m-hydroxybenzoic acid and 6-hydroxy-2-naphthoic acid.

Examples of the ester forming derivative include compounds where the hydroxy group of the aromatic hydroxycarboxylic acid is esterified, for example, $C_2$ to $C_6$ alkanoyl esters and benzoyl esters; and compounds where carboxyl group is esterified, for example, $C_1$ to $C_6$ lower alkyl esters, phenyl esters and benzoyl esters.

Preferred examples of the ester forming derivative of the aromatic hydroxycarboxylic acid are p-acetoxybenzoic acid and p-phenoxybenzoic acid.

In the production of the wholly aromatic polyesters, the whole amount of the ester forming derivative is composed of an ester forming derivative of p-hydroxybenzoic acid, or a mixture composed of at least 60 mol% of an ester forming derivative of p-hydroxybenzoic acid and not more than 40 mol% of ester forming derivatives of other aromatic hydroxycarboxylic acids is used to introduce the units A into the main chain of the polymer.

(B) Residue of aromatic diol

The units B are derived form at least one the aromatic diol and are represented by the formula (ii) wherein $Ar^2$ is p-phenylene group (which is a residue of hydroquinone), or 4,4′-diphenylene group (which is a residue of 4,4′-dihydroxybiphenyl).

To introduce the units B into the main chain of the polymer in the production of the wholly aromatic polyester, there are used ester forming derivatives of aromatic diols having the formula:

HO - $Ar^{21}$ - OH

wherein $Ar^{21}$ is a divalent aromatic group which is p-phenylene group or 4,4′-diphenylene group.

Examples of the aromatic diol having the formula HO-$Ar^{21}$-OH include hydroquinone, 4,4′-dihydroxydiphenyl, etc.

As the ester forming derivative, compounds where hydroxy groups of the aromatic diols are esterified, such as $C_2$ to $C_6$ alkanoyl esters and benzoyl esters can be used.

Examples of the ester forming derivatives include p-diacetoxybenzene and 4,4′-diacetoxydiphenyl.

If desired, part of the units B in the wholly aromatic polyester may be replaced by units, represented by the following structural formula:

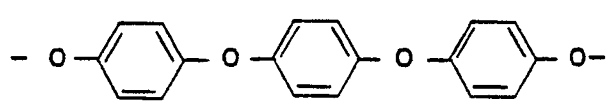

(C) Residue of 4,4′-dihydroxydiphenyl ether

To introduce the units C ether into the main chain of the polymer in the production of the wholly aromatic polyester of the present invention, there is used an ester forming derivative of 4,4′-dihydroxydiphenyl ether having the formula:

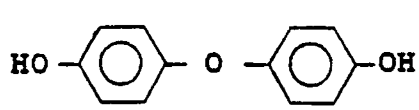

As the ester forming derivative, those compounds where the hydroxy groups are esterified, such as $C_2$ to $C_6$ lower alkanoyl esters and benzoyl esters can be used. An example of the ester forming derivative is

4,4′-diacetoxydiphenyl ether.

(D) Residue of aromatic carboxylic acid

The units D are derived from at least one aromatic carboxylic acid and are represented by the formula (iv) wherein $Ar^3$ is a divalent aromatic hydrocarbon group and at least 60 mol% of $Ar^3$ is p-phenylene group. Namely, $Ar^3$ is p-phenylene group (which is a residue of terephthalic acid), or at least 60 mol% of $Ar^3$ is p-phenylene group and not more than 40 mol% of $Ar^3$ is a divalent aromatic hydrocarbon group other than p-phenylene group. Examples of the $Ar^3$ group other than the residue of terephthalic acid include m-phenylene group, 2,6-naphthylene group, 2,7-naphthylene group and groups represented by the following formulas:

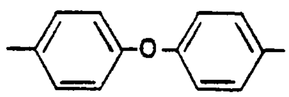

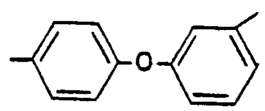

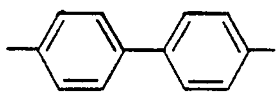

To introduce the units D into the main chain of the polymer in the production of the wholly aromatic polyester of the present invention, there are used an aromatic dicarboxylic acid having the formula
HOOC - $Ar^{3'}$ -COOH
wherein $Ar^{3'}$ is a divalent aromatic group such as p-phenylene group; or an ester forming derivatives of said aromatic dicarboxylic acid.

Examples of the aromatic dicarboxylic acid having the formula HOOC-$Ar^{3'}$-COOH include aromatic dicarboxylic acids having 8 to 15 carbon atoms such as terephthalic acid, 4,4′-dicarboxydiphenyl ether, 3,4′-dicarboxydiphenyl ether, 4,4′-dicarboxydiphenyl, isophthalic acid, 2,6-dicarboxynaphthalene, 2,7-dicarboxynaphthalene, etc.

As the ester forming derivatives of the aromatic dicarboxylic acid having the formula HOOC-$Ar^{3'}$-COOH, those compounds where the carboxyl groups are esterified, such as $C_2$ to $C_6$ lower alkyl esters, phenyl esters and benzyl esters can be used.

In the production of the wholly aromatic polyester of the present invention, the whole amount of the aromatic dicarboxylic acid reactant is composed of terephthalic acid or its ester, or a mixture consisting of at least 60 mol% of terephthalic acid or its esters and not more than 40 mol% of other aromatic dicarboxylic acid or its ester is used to introduce the units having the formula (iv) into the main chain of the polymer.

In the first wholly aromatic polyester composition of the present invention, the main chain of the wholly aromatic polyester is mainly composed of the units A, B, C and D in such proportions that the amount of the units A is from 30 to 80 mol%, preferably 40 to 70 mol%; the amount of the units B (in the case of the residue of hydroquinone) is from 1 to 20 mol%, preferably 3 to 16 mol% or that of the residue B (in the case of the residue of 4,4′-dihydroxyphenyl)is from 1 to 20 mol%, preferably 3 to 18 mol%; the amount of the units C is from 1 to 32 mol%, preferably 3 to 24 mol%; and the amount of the units D is from 10 to 35 mol%, preferably 15 to 30 mol%, with the proviso that the sum of moles of the units B and C is substantially equal to moles of the units D.

In the first wholly aromatic polyester composition of the present invention, up to 40% of the sum of moles of the units B and C can be replaced by one or more aromatic units selected from the class consisting of units of resorcin, units of 3,4′-dihydroxydiphenyl, units of 2,6-dihydroxynaphthyl and units having the following formulas

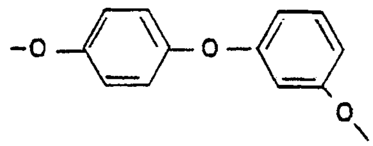

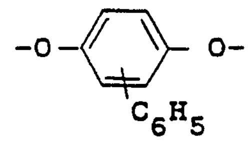

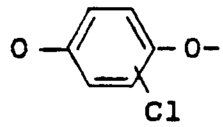

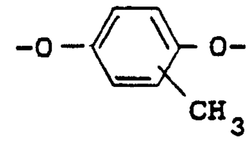

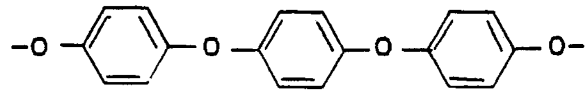

and

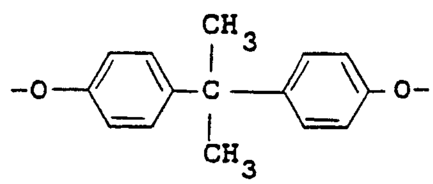

Such aromatic units can be introduced into the main chain of the polymer by using the ester forming derivatives of aromatic diols such as resorcin, 3,4-dihydroxydiphenyl, 2,6-dihydroxynaphthalene, 3,4′-dihydroxydiphenyl ether, phenylhydroquinone, chlorohydroquinone, methylhydroquinone and 2,2-bis(4-hydroxyphenyl)propane in place of the units B.

The wholly aromatic polyesters can be melt-molded and it is preferred that the wholly aromatic polyesters have a melt viscosity of $10^6$ to $10^7$ P as measured at a shear rate of 100 $sec^{-1}$ and at a temperature of higher by 30 °C than their inherent melting point.

The wholly aromatic polyesters are substantially linear and the polymer chains thereof may be terminated by any of the above-described residues. Further, compounds where the terminal carboxyl groups of the wholly aromatic polyesters are esterified with a monohydric lower alcohol such as methanol, ethanol or isopropanol or a monohydric aromatic hydroxy compound such as phenol or cresol and compounds where the terminal hydroxy groups are esterified with a monocarboxylic acid such as acetic acid, propionic acid or benzoic acid, are included within the scope of the present invention.

## Filler

Conventional fillers which have been used for the purpose of improving the mechanical strength and other properties of synthetic resins, can be used as such in the present invention without particular limitation.

Examples of the fillers which can be used in the present invention include inorganic fibers such as glass fiber, carbon fiber, potassium titanate fiber, stainless steel fiber, etc.; earth crust forming substances such as talc, clay, kaolin, silica, diatomaceous earth, mica powder, asbestos, alumina graphite, etc.; metal salts such as calcium carbonate, calcium silicate, barium sulfate, aluminum sulfate, calcium sulfate, basic magnesium carbonate, molybdenum disulfide, etc.; hydroxides such as aluminum hydroxide, calcium hydroxide, barium hydroxide, etc.; and other materials such as wallastonite, glass bead, aluminum flake, Shiras balloon, etc. Among them, glass fiber, carbon fiber, potassium titanate fiber, talc, wallastonite, etc. are particularly preferred.

The filler is blended in such an amount that the wholly aromatic polyester resin composition contains the wholly aromatic polyester [I] and the filler [II] in a ratio of I/II of 10/90 to 90/10, preferably 30/70 to 60/40 by weight.

The filler may be in the form of a fiber or a particle. The shape of the filler is chosen according to the properties of products to be formed. When the filler is in the form of a fiber, it is desirable that fiber length

is 5µm to 10 mm and fiber diameter is 0.1 to 20 µm. When the filler is in the form of a particle, it is desirable that particle diameter is 0.1 to 50 µm.

If desired, conventional additives such as stabilizer, antistatic agent, flame retarder, pigment, dye, lubricant, blowing agent, etc., in addition to said wholly aromatic polyester and said filler may be added to the wholly aromatic polyester compostion of the present invention.

Now, a second wholly aromatic polyester composition of the present invention will be illustrated below.

The second wholly aromatic polyesters composition comprises the melt-moldable wholly aromatic polyester [I] and the filler [II], said polyester [I] being composed of A units A of aromatic hydroxycarboxylic acid, C′ units B of aromatic diol and D units C′ of aromatic dicarboxylic acid in such proportion that the amount of the units A is 30 to 80 mol%, preferably 40 to 70 mol%, that of the units C′ is 10 to 35 mol%, preferably 15 to 30 mol% and that of the units D is 10-35 mol%, preferably 15-35 mol%, based on the sum of moles of the units A, C′ and D, with the proviso that moles of the units C′ being substantially equal to moles of the units D, wherein the ratio of the wholly aromatic polyester [I] to the filler [II] is from 10/90 to 90/10 by weight.

The units A and D in the wholly aromatic polyester of the second wholly aromatic polyester composition are the same as the unitss A and D in the wholly aromatic polyester of the first wholly aromatic polyesters composition. The polyester in the second composition is different from the polyester in the first composition in that the units C′ are used.

The units C′ in the wholly aromatic polyester of the second wholly aromatic polyester composition can be represented by the structural formula $-O-Ar^4-O-$ wherein $Ar^4$ is a divalent aromatic group of at least 60 mol% of $Ar^4$ is selected from the class consisting of a group having the formula (a)

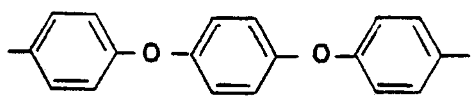

... (a)

and a group having the formula (b)

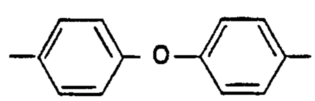

... (b)

To introduce the units C′ into the main chain of the polymer, there are used ester forming derivatives of an aromatic diols having the following formula

$HO - Ar^4 - OH$

wherein $Ar^4$ is a divalent aromatic group, at least 60 mole % of $Ar^4$ is selected from the class consisting of a group of the formula (a), and a group of the formula (b).

Examples of the aromatic diol having the formula $HO-Ar^{4'}-OH$ include aromatic diols having 6 to 15 carbon atoms such as 4,4′-dihydroxyphenyl ether, 1,4-bis(4′-hydroxyphenoxy)benzene, hydroquinone, 4,4′-dihydroxydiphenyl, resorcin, 3,4′-dihydroxydiphenyl, 3,4′-dihydroxydiphenyl ether, phenylhydroquinone, chlorohydroquinone, methylhydroquinone, 2,2-bis(4- hydroxyphenyl)propane, etc.

As the ester forming derivative of the aromatic diol, those compounds where the hydroxy groups are esterified, such as $C_2$ to $C_6$ lower alkanoyl esters and benzoyl esters can be used.

To introduce the units C′ into the main chain of the polyester of the second composition, ester forming derivatives of 1,4-bis(4′-hydroxyphenoxy)benzene and 4,4′-dihydroxydiphenyl ether may be used alone or in combination. Alternatively, there can be used a mixture consisting of at least 60 mol%, preferably not more than 70 mol% of an ester forming derivative of 1,4-bis(4′-hydroxyphenoxy)benzene and/or 4,4′-dihydroxydiphenyl and not more than 40 mol%, preferably not more than 30 mol% of ester forming derivatives of other aromatic diols.

Preferred examples of the units C′ are those where $Ar^4$ in the formula (V) is a group of the formula (a) [which is the residue of 1,4-bis(4-hydroxyphenoxy)benzine], and/or a group of the formula (b) (which is the residue of 4,4′-dihydroxydiphenyl ether) and $Ar^4$ is a group of the where at least 70 mol% of $Ar^4$ is a group of the formula (a) and/or a group of the formula (a) and not more than 30 mol% of $Ar^4$ are derived from other aromatic diols.

The molar ratio of the group having the formula (a) to the group having the formula (b) is preferably from 100:0 to 10:90, more preferably 80:20 to 20:80.

The wholly aromatic polyesters can be melt-molded and it is desirable that said polyesters have a melt

viscosity of $10^2$ to $10^7$ P as measured at a shear rate of 100 $sec^{-1}$ and at a temperature of higher by 30 °C than their inherent melting point.

Process for producing wholly aromatic polyester composition

The wholly aromatic polyester of the present invention can be produced in the following manner.

As starting materials, there is used a mixture comprising at least one aromatic hydroxycarboxylic acid ester for the formation of the units A, at least one aromatic diol or its ester for the formation of the units B an ester forming derivative of 4,4′-dihydroxydiphenyl ether for the formation of the units C and at least one aromatic dicarboxylic acid or its ester for the formation of the units D. If desired, a catalyst such as aluminum acetate is used. The catalyst is used in an amount of 0.0001 to 1% by weight based on the total amount of the starting materials.

For example, when a mixture consisting of acetate ester of a hydroxycarboxylic acid, an aromatic dicarboxylic acid and bisacetate ester of aromatic diols is used as a starting material, the mixture is heated at a temperature of 200 to 450 °C, preferably 250 to 400 °C. Preferably, heating is conducted under a pressure of from atmospheric pressure to a vacuum of 0.1 mmHg. Acetic acid concomitantly formed by the reaction is distilled off. When a mixture consisting of a phenyl ester of a hydroxycarboxylic acid, a bisphenol ester of an aromatic dicarboxylic acid and an aromatic diols is used as a starting material, the mixture is heated at a temperature of 200 to 450 °C, preferably 250 to 400 °C. Heating is generally conducted under a pressure of from atmospheric pressure to a vacuum of 0.1 mmHg. Phenol formed by the reaction is distilled off.

The formed wholly aromatic polyester is mixed with a filler and optionally, other compounding ingredients in a mixer such as Henschel mixer, drum blender, ribbon blender or the like. The resulting mixture is kneaded in an extruder, Banbury mixer, mixing roll, drum blender, ribbon blender, kneader or the like.

The thus-obtained wholly aromatic polyester composition has a reduced anisotropy in mechanical strength as well as excellent mechanical characteristics (e.g., flexural modulus, tensile strength, impact strength, etc.), high heat resistance, high hydrolysis resistance and improved melt moldability and can be widely used in various applications.

Examples of uses

The thus-obtained wholly aromatic polyester compositions and the wholly aromatic polyesters can be used in the following fields.

(i) Sealing materials for electronic components such as capacitors, resistors, integrated circuits, coils, microswitches, etc.

The aromatic polyester compositions, and the sealing material comprising the wholly aromatic polyesters do not corrode oppositing members, are excellent in moldability, heat resistance, mechanical characteristics and dimensional stability, can be injection-molded and are excellent in productivity.

(ii) Connectors

Examples thereof include heat-resistant connectors, heat-resistant sockets, connectors for optical communication, etc.

The connectors composed of said wholly aromatic polyester compositions or said wholly aromatic polyesters are excellent in melt-moldability, heat resistance, mechanical characteristics, dimensional stability and dimensional precision, do not corrode electrodes or wirings, and are excellent in productivity.

(iii) Base for printed circuits

The base boards for printed circuits, composed of said wholly aromatic polyester compositions or said

wholly aromatic polyester are excellent in melt-moldability, heat resistance, mechanical strength, dimensional stability and dimensional precision, do not corrode electrodes and wirings and are excellent in productivity.

In addition to the uses described above, the wholly aromatic polyester compositions and wholly aromatic polyesters of the present invention can be used in the following fiedls.

Electrical components

For example, hair dryer (e.g. housing, etc.), components for washing machines (e.g., bearing, valve, cock, rotor, etc.), video components (e.g., brake ring, etc.), parts for dishwashers (e.g., housing etc.), parts for tape recorders (e.g., bearing, etc.), clothing-drying machine (e.g., bin, etc.), parts for microwave range (e.g., sensor case, etc.), motor parts (e.g., commutator, brush holder, parts for coreless motors, etc.), lamp holders (e.g., sockets for projectors and halogen lamps, etc.), potentiometer (e.g., coil former, etc.), parts for soldering bit, cassette roll stand, parts for record players (e.g., tone arm, bearing, etc.), etc.

Electronic components

Relay parts (e.g., housing, arc insulator, etc.), electronic components, switches (e.g., housing, etc.), bobbin, parts for electronic clock (e.g., housing, stator for trimmer condenser, insulater, etc.), parts for level switches, parts for electronic switchboards (e.g., microwave absorbing part, bobbin, etc.), parts for supersonic flaw detector (e.g., sensor, etc.), parts for electronic tube (e.g., insulating ring, etc.), holder for electronic components, parts for apparatus for measuring internal pressure of cylinder of internal combustion engine (e.g., ring element insulator, etc.), parts for battery (e.g., catalyst holder, etc.), resistors, parts for hearing aid, parts for surface thermometer (e.g., coupling part, etc.), fuse parts (e.g., housing, etc.), etc.

Automobile parts

For example, EGR valve (e.g., valve body, valve cover, valve, etc.), piston ring, avex seal, plug insulating material, parts for shock absorber (e.g., ring, bearing, etc.), parts for bulldozer (e.g., piston ring, bearing, etc.), parts for distributor (e.g., cam, housing, etc.), parts for ignition switch (e.g., housing, etc.), brake parts (e.g., brake material, binder, brake, bleeder, etc.), parts for exhaust gas pipe (e.g., sleeve, etc.), temperature sensor for exhaust gas (e.g., housing, etc.), wire cable, lamp parts (e.g., head lamp reflector, etc.), automative cooler, sliding material, etc.

Mechanical parts

For example, parts for copying machine (e.g., bearing, stripper finger, hot roll coating, etc.), parts for computer (e.g., wear-resistant ring, etc.), parts for line printer (e.g., guide, back-up ring, etc.), parts for compressor (e.g., piston ring, blade, etc.), sliding material for apparatus for producing Japanese soy, parts for paper-making drier, parts for spinning machine (e.g., spindle, pulley, climper guide, etc.), parts for projector, parts for vending machine (e.g., bearing, etc.), tools for glass production, tools for producing CRT, tools for canning, tools for bottle manufacturing (e.g., delivery pack, etc.), stern bearing, oilless bearing (e.g., oil-containing bearing, three-layer bearing, etc.), underwater bearing, heat-resistant bearing for sterile works, roller bearing (e.g., track wheel, etc.), parts for valve (e.g., valve seat, plug, etc.), packing, conveyor belt, mechanical seal, pulley, air pump (e.g., rotor, etc.), linear compressor (e.g., piston, etc.), lock parts, reflow solder parts, guide pin for welding, transfer valve for liquid chromatography, pump parts for digging out crude oil (e.g., insulating washer, etc.), parts for extruder (e.g., die, etc.), camera body, parts for gas calorimeter (e.g., housing, etc.), parts for sewing machine (e.g., cam, etc.), parts for lighter (e.g., housing, etc.), parts for dial gauge, insulating material for stator of refrigerator, parts for air conditioner (e.g., muffler, etc.), parts for robot, bearing for oven, gasoline filter, etc.

Other parts

For example, parts for synchrotron, TLD parts (e.g., cap, etc.), abradable sheel, binder for abrasive stone, simple mold, heat-resistant fiber, tablewave for aircraft, ski. etc.

Now, a third wholly aromatic polyester compositions of the present invention will be illustrated below.

The third wholly aromatic polyester composition of the present invention comprises:

[I] a melt-moldable wholly aromatic polyester consisting essentially of:

(A) structural units A derived from at least one aromatic hydroxycarboxylic acid, represented by the formula (i)

$- CO - Ar^1 - O -$ (i)

wherein $Ar^1$ is a divalent hydrocarbon group and at least 60 mol% of $Ar^1$ is p-phenylene group;

(B) structural units B derived from at least one aromatic diol, represented by the formula (ii)

$- O - Ar^2 - O -$ (ii)

wherein $Ar^2$ is a divalent aromatic group selected from the class consisting of a p-phenylene group and 4,4′-biphenylene group;

(C) structural units C derived from 4,4′-dihydroxydiphenyl ether, represented by the formula (iii)

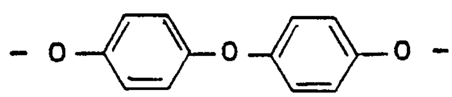

... (iii)

and

(D) structural units D derived from at least one aromatic dicarboxylic acid, represented by the formula (iv)

$- CO - Ar^3 - CO -$ (iv)

wherein $Ar^3$ is a divalent aromatic group and at least 60 mol% of $Ar^3$ is p-phenylene group; in such proportions that the amount of the units A is 30 to 80 mol%, that of the units B is 1 to 20 mol%, that of the units C is 1 to 32 mol%, that of the units D is 10 to 35 mol%, with the proviso that the sum of moles of the units B and C is substantially equal to moles of the units D and

[II] a thermoplastic synthetic resin in such an amount that the amount of the wholly aromatic polyester [I] is 5 to 95% by weight based on the combined amount of said polyester [I] and said thermoplastic synthetic resin [II].

The fourth wholly aromatic polyester composition of the present invention comprises:

[I] a melt-moldable wholly aromatic polyester consisting essentially of:

(A) structural units A derived from at least one aromatic hydroxycarboxylic acid, represented by the formula (i)

$- CO - Ar^1 - O -$ (i)

wherein $Ar^1$ is a divalent aromatic hydrocarbon group and at least 60 mol% of $Ar^1$ is p-phenylene group;

(C)′ structural units B derived from at least one aromatic diol, represented by the formula (ii)

$- O - Ar^4 - O -$ (ii)

wherein $Ar^4$ is a divalent aromatic group and at least 60 mol% of $Ar^4$ is selected from the class consisting of a group having the formula (a)

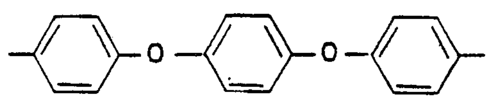

... (a)

and a group having the formula (b)

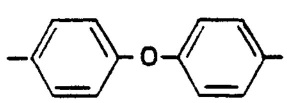

... (b)

and

(D) structural units D derived from at least one aromatic dicarboxylic acid, represented by the formula (iii)

$- CO - Ar^3 - C -$ (iii)

wherein $Ar^3$ is a divalent aromatic hydrocarbon group and at least 60 mol% of $Ar^3$ is p-phenylene group; in

such proportions that the amount of the units A is 30 to 80 mol%, that of the units C′ is 10 to 35 mol% and that of the units D is 10 to 35 mol%, based on the sum of moles of the units A, C′ and D, with the proviso that moles of the units C′ being substantially equal to moles of the units D,
and

[II] a thermoplastic resin in such a proportion that the amount of the wholly aromatic polyester is 5 to 95% by weight based on the combined amount of said polyester and said thermoplastic resin.

As the thermoplastic resin to be incorporated in the third and fourth wholly aromatic polyester compositions of the present invention, various plastics such as engineering plastics can be used.

Examples of the thermoplastic resins include polyamide, polycarbonate, polyphenylene sulfide, polyphenylene oxide, polyether sulfone, polyether ether ketone, polysulfone, polyalkylene terephthalate, polyoxybenzylene, polymethylpentene, polyacrylate, polyimide, polyamide-imide, bisareimide maleimide, etc.

Preferred examples of the polyamide are poly- -caprolactam (nylon 6), polyhexamethyleneadipamide (nylon 66), poly- -aminoundecanoic acid (nylon 11), poly- -aminolaurolactam (nylon 12) and those composed of two or more components of these polyamides.

Preferred examples of the polycarbonate are polymers composed of repeating units having the following formula:

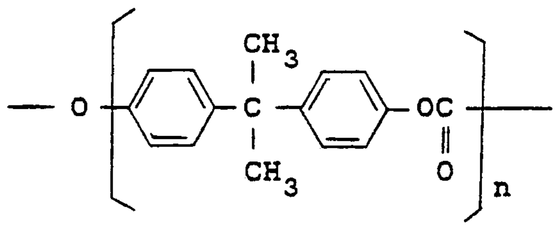

wherein n is a number which represents a degree of polymerization.

Preferred examples of the polyphenylene sulfide are polymers composed of recurring units having the following formula:

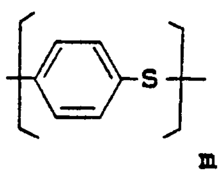

wherein m is a number which represents a degree of polymerization.

Preferred examples of the polyphenylene oxide are polymers composed of recurring units having the following formula:

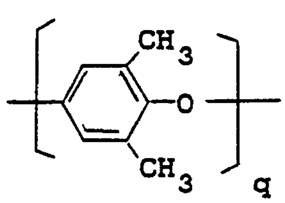

wherein q is a number which represents a degree of polymerization.

Preferred examples of the polyether sulfone are polymers composed of recurring units having the following formula

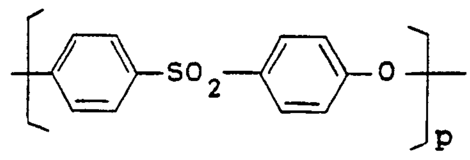

wherein p is a number which represents a degree of polymerization.

Preferred examples of the polyether ether ketone are polymers composed of recurring units having the following formula:

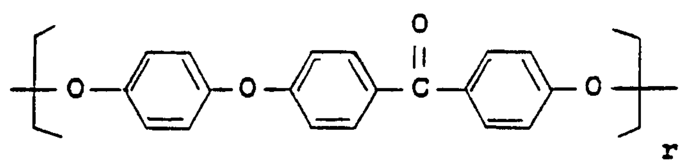

wherein r is a number which represents a degree of polymerization.

Preferred examples of the polysulfone are polymers composed of a recurring units having the following formula:

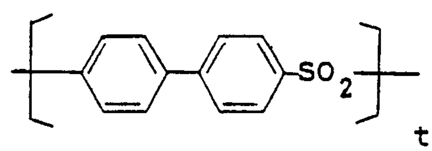

wherein t is a number which represents a degree of plymerization.

As the polyalkylene terephthalate, polyethylene terephthalate (PET) and polybutylene terephthalate (PBT) are preferred.

Other resins which are known as engineering plastics such as polyoxybenzylene, polymethylpentene, polyarylate, polyimide, polyamide-imide and bisureimide maleimide, can also be used in the present invention.

Among these resins, polyamide, polycarbonate, polyphenylene sulfide, polyether sulfone, polyether ether ketone and polyalkylene terephthalate are particularly preferred as the synthetic thermoplastic resins.

The blends of the wholly aromatic polyesters according to the present invention contain 5 to 95 % by weight, preferably 10 to 80 % by weight of the wholly aromatic polyester based on the combined amount of the wholly aromatic polyester [I] and the synthetic thermoplastic resin [II].

The third and fourth wholly aromatic polyester compositions may contain the fillers described above.

The third and fourth wholly aromatic polyester compositions of the present invention can be produced in a similar manner to that described for the production of the first and second wholly aromatic polyester compositions of the present invention.

The invention is further illustrated by means of the following examples without limiting the invention thereto.

Example 1

A mixture of 0.6 mol of p-acetoxybenzoic acid, 0.05 mol of p-diacetoxybenzene, 0.15 mol of 4,4′-diacetoxydiphenyl ether and 0.2 mol of terephthalic acid was placed in a reactor having a capacity of 500 mol and heated to 275 °C for one hour under stirring. Acetic acid formed by the reaction was distilled off. While heating the reaction mixture to 350 °C over a period of two hours, the pressure in the reactor was reduced to 0.5 mm Hg. The reaction mixture was heated at the same temperature and presure.

The thus-obtained wholly aromatic polyester was composed of 60 mol% of a residue of p-hydroxybenzoic acid, 5 mol% of a residue of hydroquinone, 15 mol% of a residue of 4,4′-dihydroxydiphenyl ether and 20 mol% of a residue of terephthalic acid, based on the sum of moles of the entire structural units.

The wholly aromatic polyester was powdered. A mixture of 70 wt.% of said wholly aromatic polyester powder [I] and 40 wt.% of filler [II] composed of glass fiber having a length of 3 mm and a diameter of 13µm was kneaded in a 45 mmØ vented twin-screw extruder (PCM-45, manufactured by Ikegai Iron Works, Ltd.) preset to 350 °C, while melting the wholly aromatic polyester. The resulting product was pollectized.

The thus-obtained wholly aromatic polyester composition was molded in the following manner. The physical properties of the resulting molded article were measured in the manners described below.

Molding shrinkage factor

The wholly aromatic polyester composition was injection-molded into a square sheet of 120 x 130 x 2 mm by injecting under a injection pressure of 800 kg·cm$^2$ at a temperature of 320 °C., it into a mold heated to 100 °C. In the molded sheet there was observed a mark indicating that the resin had flowed in a certain direction during the injection molding, A direction parallel to the direction of resin flow will be referred to herein as the longitudinal direction (L.D.), while a direction perpendicular to the direction of resin flow will be referred to herein as the transverse direction (T.D.) Forty eight hours after the injection molding, a molding shrinkage factor, that is, a % shrinkage of the molded sheet based on the size of the mold was determined in both the longitudinal and transverse directions.

Warpage

The molded sheet was placed on a table with one while the remaining three ends of the sheet were unfixed, end of the sheet fixed to the table, after 48 hours, there was measured a distance from the table to that end where the warpage was maximum among the three ends. When the warpage was 10 mm or larger, the warpage was referred to as large, while when it was 5 mm or smaller, the warpage was referred to as small.

Coefficient of linear expansion

The composition was molded into a square bar of 12.7 x 127 x 3.2 mm. A test piece of about 4 x 6 x 3.2 mm was cut out from the central part of said bar. Changes of the test piece in longitudinal and transverse dimensions caused by temperature rise in the range of 40 to 60 °C were measured by using SSC 580 type (manufactured by Seiko Denshi K.K) to determine coefficients of linear expansion in both the longitadinal and trausverse directions. The results are shown in Table 1.

Weld strength

A welded test piece and a non-welded test piece were prepared from No. 1 test pieces according to JIS K 6301. Tensile strength and retention were determined.

Flexural strength and flexural modulus

A square sheet of 120 x 130 x 2 mm (side gate) was molded. A rectangular test piece was cut out (longitudinal: 12.7 mm, transverse: 127 mm) from the central part of the square sheet, and subjected to a flexural test according to ASTM D790 to determine flexural strength and flexural modulus in both the longitudinal and trausverse directions. Results are shown in Table 1.

Example 2

The procedure of Example 1 was repeated except that talc having an average particle size of 10 to 20 µm was used as a filler in place of the glass fiber, and heat a mixture 60 mol% of the wholly aromatic polyester [I] and 40 wt.% of talc was 40 wt.% of talc was used. The various tests were carried out. Results are shown in Table 1.

Referential Example 1

The procedure of Example 1 was repeated except that glass fiber was omitted. Test pieces were prepared as in Example 1 and tested as in Exampule 1. Results are shown in Table 1.

Table 1

| | | Example 1 | | Example 2 | | Refrential Ex.1 | |
|---|---|---|---|---|---|---|---|
| Filler | | Glass fiber | | Talc | | | |
| Amount (wt %) | | 30 | | 40 | | | |
| Mold shrinkage factor (%) | | L.P. | T.D. | L.P. | T.D. | L.P. | T.D. |
| | | 0.0 | 0.4 | 0.1 | 0.7 | -0.1 | 1.3 |
| Warpage | | small | | small | | large | |
| Coefficient of linear expansion x $10^{-5}$(cm/cm) | | 1.5 | 1.5 | 1.0 | 2.0 | 0.5 | 0.8 |
| Weld strength | Non-welded | 1620 | | 990 | | 1040 | |
| | Welded | 230 | | 220 | | 110 | |
| | Retention (%) | 14 | | 22 | | 11 | |
| Flexural strength (kg/cm$^2$) | | 2100 | 1100 | 1400 | 700 | 1500 | 650 |
| Flexural modulus ($10^3$kg/cm$^2$) | | 95 | 45 | 60 | 40 | 70 | 20 |

Referential Example 2

In a similar manner to that described in Example 1, there was synthesized a wholly aromatic polyester composed of 60 mol% of a residue of p-hydroxybenzoic acid, 6 mol% of a residue of hydroquinone, 12 mol% of a residue of 4,4′-dihydroxydiphenyl ether, 2 mol% of a residue of 1,4-bis-(4-hydroxyphenoxy)-benzene and 20 mol% of a residue of terephthalic acid, based on the sum of moles of the entire structural units.

Referential Example 3

In a similar manner to that described in Example 1, there was synthesized a wholly aromatic polyester composed of 60 mol% of a residue of p-hydroxybenzoic acid, 10 mol% of a residue of 4,4′-dihydroxydiphenyl, 10 mol% of a residue of 4,4′-dihydroxydiphenyl ether and 20 mol% of a residue terephthalic acid, based on the sum of moles of the entire structural units.

Example 3

A sealing material was prepared using the wholly aromatic polyester obtained in Example 1. The physical properties of the sealing material were measured. Results are shown in Table 2.

Example 4

A sealing material was prepared using a composition obtained by blending 30% by weight of glass fiber with the wholly aromatic polyester obtained in Example 1. The physical properties thereof were measured.

Results are shown in Table 2.

Example 5

A sealing material was prepared using a composition obtrained by blending 40% by weight of talc with the wholly aromatic polyester obtained in Example 1. The physical properties thereof were measured. Results are shown in Table 2.

Table 2

| | Example 3 | Example 4 | Example 5 |
|---|---|---|---|
| Filler | --- | Glass fiber | Talc |
| Heat distortion temp.(°C) ASIM D 648 (18.6kg/cm$^2$) | 180 | 230 | 190 |
| Notched izod impact strength (kg.cm/cm) ASIM D 256 | 50 | 20 | 10 |
| Tensile strength (kg/cm$^2$) ASIM D 790 | 1500 | 2100 | 1400 |
| Flexural strength (10$^3$kd/cm$^2$) ASIM D 790 | 70 | 95 | 60 |
| Critical oxygen index (%) ASIM D 2863 | 40 | 40 | 40 |

Example 6

A connector was prepared using the wholly aromatic polyester obtained in Example 1. The physical properties thereof were measured and it was found that results similar to those of Example 3 in Table 2 were obtained.

Example 7

A connector was prepared using a composition obtained by blending 30% by weight of glass fiber with the wholly aromatic polyester obtained in Example 1. The physical properties of the connector were measured and it was found that results similar to those of Example 4 in Table 2 were obtained.

Example 8

A connector was prepared using a composition obtained by blending 40% by which of talc with the wholly aromatic polyester obtained in Example 1. The physical properties of the connector were measured and it was found that results similar to those of Example 5 in Table 2 were obtained.

Example 9

A base board for printed circuit was prepared using the wholly aromatic polyester obtained in Example 1. The physical properties thereof were measured and it was found that results similar to those of Example 3 in Table 2 were obtained.

Example 10

A base board for printed circuit was prepared using a composition obtained by blending 30% by weight of glass fiber with the wholly aromatic polyester obtained in Example 1. The physical properties thereof

were measured and it was found that results similar to those of Example 4 in Table 2 were obtained.

Example 11

A base board for printed circuit was prepared using a composition obtained by blending 40% by weight of talc with the wholly aromatic polyester in Example 1. The physical properties thereof were measured and it was found that results similar to those of Example 5 in Table 2 were obtained.

Example 12

The wholly aromatic polyester obtained in Example 1 was mixed with a polyamide in ratios given in Table 3. The resulting mixture was fed to a 45 mmØ vented twin-screw extruder (PCM-45, manufactured by Ikegai Iron Works, Inc.) heated to 350 °C, melt-kneaded and pelletized. The particulate material was injection-molded to prepare each test piece for evaluation of physical properties.

Each test piece for the evaluation of physical properties was prepared by cutting out each test piece of 12.7 x 127 x 2 mm [longitudinal direction (direction of flow of resin): 12.7 mm, transverse direction (direction perpendicular to the direction of flow of resin): 127 mm] from the central part of each square sheet (side gate) of 120 x 130 x 2 mm. Flexural strength and flexural modulus were measured according to ASTM D790. Results are shown in Table 3.

Table 3

| Run.No. | 1 | 2 | 3 | 4 | 5 |
|---|---|---|---|---|---|
| Nylon 66 (wt %) | 100 | 70 | 50 | 30 | 0 |
| LCP (Wt %) | 0 | 30 | 50 | 70 | 100 |
| Flexural strength (FS) ($kg/cm^2$) | 1100 | 1250 | 1350 | 1400 | 1500 |
| Flexural modulus (FM) ($kg/cm^2$) | 30000 | 45000 | 50000 | 62000 | 70000 |

Example 13

The procedure of Example 12 was repeated except that a polycarbonate resin (Panlite L-1250, a product of Teijin Kasei K.K.) was used in place of the polyamide resin. Results are shown in Table 4.

Table 4

| Run.No. | 1 | 2 | 3 | 4 | 5 |
|---|---|---|---|---|---|
| Polycarbonate (wt %) | 100 | 70 | 50 | 30 | 0 |
| LCP (Wt %) | 0 | 30 | 50 | 70 | 100 |
| FS ($kg/cm^2$) | 900 | 1100 | 1250 | 1400 | 1500 |
| FM ($kg/cm^2$) | 23000 | 35000 | 47000 | 60000 | 70000 |

Example 14

The procedure of Example 12 was repeated except that polybutylene terephthalate resin (PBT 1404-X06, a product of Toray Industries, Inc.) was used in place of the polyamide resin. Results are shown in Table 5.

Table 5

| Run.No. | 1 | 2 | 3 | 4 | 5 |
|---|---|---|---|---|---|
| Polybutylene terephthalate (wt %) | 100 | 70 | 50 | 30 | 0 |
| LCP (Wt %) | 0 | 30 | 50 | 70 | 100 |
| FS ($kg/cm^2$) | 900 | 1050 | 1200 | 1400 | 1500 |
| FM ($kg/cm^2$) | 25000 | 35000 | 45000 | 56000 | 70000 |

Example 15

The procedure of Example 12 was repeated except that polyphenylene sulfide resin (PPS Toprene T-4, a product of Toray Industries, Inc.) was used. Results are shown in Table 6.

Table 6

| Run.No. | 1 | 2 | 3 | 4 | 5 |
|---|---|---|---|---|---|
| Polybutylene terephthalate (wt %) | 100 | 70 | 50 | 30 | 0 |
| LCP (Wt %) | 0 | 30 | 50 | 70 | 100 |
| FS ($kg/cm^2$) | 1300 | 1350 | 1400 | 1400 | 1500 |
| FM ($kg/cm^2$) | 35000 | 47000 | 53000 | 60000 | 70000 |

Example 16

The procedure of Example 12 was repeated except that a polymer resin ($[\eta]$ = 2.1 in decalin at 130°C) of 4-methylpentene-1 was used in place of the polyamide resin. Results are shown in Table 7.

Table 7

| Run.No. | 1 | 2 | 3 | 4 | 5 |
|---|---|---|---|---|---|
| Polybutylene terephthalate (wt %) | 100 | 70 | 50 | 30 | 0 |
| LCP (Wt %) | 0 | 30 | 50 | 70 | 100 |
| FS ($kg/cm^2$) | 360 | 800 | 1000 | 1250 | 1500 |
| FM ($kg/cm^2$) | 13000 | 31000 | 41000 | 50000 | 70000 |

## Claims

1. A wholly aromatic polyester composition which comprises:

[I] a melt-moldable wholly aromatic polyester which either

(α) consists essentially of:

(A) structural units A derivable from at least one aromatic hydroxycarboxylic acid and of the formula (i)

$- CO - Ar^1 - O -$ (i)

wherein $Ar^1$ is a divalent hydrocarbon group and at least 60 mol% of $Ar^1$ is the p-phenylene group;

(B) structural units B derivable from at least one aromatic diol and of the formula (ii)

$- O - Ar^2 - O -$ (ii)

wherein $Ar^2$ is a divalent aromatic group selected from p-phenylene and 4,4′biphenylene groups;

(C) structural units C derivable from 4,4′-dihydroxydiphenyl ether and of the formula (iii)

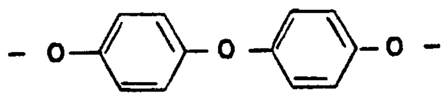

... (iii)

and

(D) structural units D derivable from at least one aromatic dicarboxylic acid and of the formula (iv)

$- CO - Ar^3 - CO -$ (iv)

wherein $Ar^3$ is a divalent aromatic hydrocarbon group and at least 60 mol% of $Ar^3$ is the p-phenylene group; in such proportions that the amount of units A is 30 to 80 mol%, that of units B is 1 to 20 mol%, that of units C is 1 to 32 mol% and that of units D is 10 to 35 mol%, based on the sum of moles of the units A, B, C and D, with the proviso that the total amount of units B and C is substantially equal to the amount of units D or

(β) consists essentially of (A) units A as defined herein

(C)′ structural units C′ derivable from at least one aromatic diol and of the formula (v)

$- O - Ar^4 - O -$ (v)

wherein $Ar^4$ is a divalent aromatic group, and at least 60 mole% of $Ar^4$ is selected from a group having the formula (a)

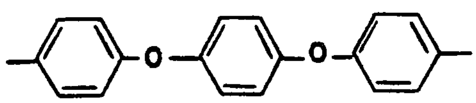

... (a)

and a group having the formula (b)

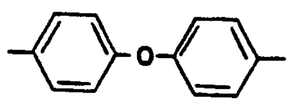

... (b)

and

(D) units D as defined herein; in such proportions that the amount of the units A is 30 to 80 mol%, that of the units C′ is 10 to 35 mol% and that of the units D is 10 to 35 mol%, based on the sum of moles of the units A, C′ and D, with the proviso that the amount of units C′ is substantially equal to the amount of units D, and

[II] a filler, in such a proportion that the ratio of the wholly aromatic polyester [I] to the filler [II] is from 10/90 to 90/10 by weight.

2. A composition according to claim 1, wherein said filler is glass fiber having a fiber length of 5 µm to 10 mm and a fiber diameter of 0.1 to 20 µm.

3. A sealing material which comprises a melt-moldable wholly aromatic polyester as defined under (α) or (β) in claim 1.

4. A sealing material according to claim 3 wherein said wholly aromatic polyester contains a filler.

5. A connector which comprises a melt-moldable wholly aromatic polyester as defined under (α) or (β) in claim 1.

6. A connector according to claim 5, wherein said wholly aromatic polyester contains a filler.

7. A base board for a printed circuit which comprises a melt-moldable wholly aromatic polyester as defined under (α) or (β) in claim 1.

8. A base board for a printed circuit according to claim 7, wherein said wholly aromatic polyester

contains a filler.

9. A wholly aromatic polyester composition which comprises:

[I] a melt-moldable wholly aromatic polyester as defined under ($\alpha$) or ($\beta$) in claim 1; and

[II] a synthetic thermoplastic resin in such a proportion that the amount of the wholly aromatic polyester [I] is 5 to 95% by weight based on the combined amount of said wholly aromatic polyester [I] and said synthetic thermoplastic resin [II].

10. A wholly aromatic polyester composition according to claim 9, wherein said synthetic thermoplastic resin is at least one polyamide, polycarbonate, polyphenylene sulfide, polyphenylene oxide, polyether sulfone, polyether ether ketone, polysulfone, polyalkylene terephthalate, polyoxybenzylene, polymethylpentene, polyacrylate, polyimide, polyamide-imide or bisareimide maleimide.

European Patent Office

# EUROPEAN SEARCH REPORT

Application Number

EP 88 31 0415

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 273 424 (KURARAY CO.) * Claims 1-16 * | 1-8 | C 08 L 67/00<br>C 08 K 3/00<br>C 08 K 7/14<br>C 08 G 63/60<br>H 05 K 5/00<br>H 01 R 13/527<br>H 05 K 1/03 |
| D,Y | EP-A-0 237 358 (MITSUI PETROCHEMICAL INDUSTRIES) * Claims 1-18 * | 1-8 | |
| Y | EP-A-0 264 290 (POLYPLASTIER CO.) * Claims 1-6 * | 1-8 | |
| A | EP-A-0 271 326 (POLYPLASTICS CO.) * Claims 1-10; page 2, lines 1-7 * | 1-8 | |
| A | EP-A-0 183 088 (I.C.I.) * Claims 1-4 * | 1 | |
| A | EP-A-0 093 333 (BAYER) * Claims 1-4 * | 1,9,10 | |

TECHNICAL FIELDS SEARCHED (Int. Cl.5)

C 08 G
C 08 K
C 08 L

The present search report has been drawn up for all claims

| Place of search | Date of completion of the search | Examiner |
|---|---|---|
| THE HAGUE | 04-07-1989 | DECOCKER L. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document